# EUROPÄISCHE PATENTSCHRIFT

(11) **EP 0 403 904 B1**
(45) Veröffentlichungstag und Bekanntmachung des Hinweises auf die Patenterteilung: **20.04.1994**
(21) Anmeldenummer: 90110949.6
(22) Anmeldetag: 09.06.1990
(51) Int. Cl.: G01R 15/12, G06K 7/10, G06K 9/18

(54) **Vorrichtung und Verfahren für die Einstellung eines Messgeräts**
Device and method for adjusting a measuring device
Dispositif et méthode pour ajuster un appareil de mesure

(30) Priorität: 19.06.1989 DE 3919886
(43) Veröffentlichungstag der Anmeldung: 27.12.1990
(73) Patentinhaber: Wandel & Goltermann GmbH & Co. Elektronische Messtechnik, D-72795 Eningen (DE)
(72) Erfinder: Benz, Reiner, D-7312 Kirchheim (DE)
(74) Vertreter: Ott, Elmar, Dipl.-Ing.

(56) Entgegenhaltungen:
- EP-A- 0 150 494
- TEK(TRONIX) PRODUCTS 1988, Seite 401

## Beschreibung

Die Erfindung betrifft ein verfahren und ein Meßgerät für die Einstellung eines Meßgeräts.

Zur Durchführung einer Meßaufgabe muß bekanntlich das verwendete Meßgerät bezüglich Meßart und Meßempfindlichkeit eingestellt werden. Bei komplexen Messungen sind zur Einstellung eines Meßgeräts eine Vielzahl von Einstellschritten vorzunehmen, wobei unbedingt darauf zu achten ist, daß sämtliche Einstellschritte fehlerfrei vorgenommen werden. Im Prüffeld zur Endkontrolle von elektrischen Geräten oder zum Ausmessen von Nachrichtenübertragungsstrecken werden häufig wiederkehrende, standardisierte Meßaufgaben durchgeführt, wobei zur Einstellung der Meßgeräte umfassende Einstellvorschriften und Einstellanweisungen berücksichtigt werden müssen. Bei herkömmlichen Meßgeräten muß von der Bedienungsperson mit hoher Konzentration und mit hohem Zeitaufwand die Einstellung des Meßgerätes auf die gewünschte Meßaufgabe vorgenommen werden.

Meßgeräte mit einer als Fernsteuereingang verwendbaren Schnittstelle lassen sich zwar mittels eines an den Fernsteuereingang angeschlossenen Rechners auf verschiedene Meßaufgaben einstellen, jedoch erfordert dies einen hohen technischen Aufwand, der nur bei Spezialanwendungen gerechtfertigt ist.

Der Erfindung liegt die Aufgabe zugrunde, ein Verfahren für die Einstellung eines Meßgeräts zur Durchführung unterschiedlicher Meßaufgaben zu schaffen, wobei die Einstellung möglichst einfach und sicher durchführbar sein soll.

Die Lösung dieser Aufgabe wird durch die im Hauptanspruch angegebenen Merkmale erhalten. Mittels einer Strichcode-Leseeinrichtung können die als Strichcode (Barcode) vorliegenden Einstellinformationen fehlerfrei gelesen werden, so daß ein Prozessor auf der Grundlage der gelesenen Einstellinformationen die zur Einstellung des Meßgerätes erforderlichen Steuersignale erzeugt und damit die Durchführung der erforderlichen Einstellschritte veranlaßt. Es ist somit eine schnelle, sichere, handliche und preiswerte Eingabe von wiederkehrenden Einstellungen von Meßgeräten aus einer unbegrenzten Anzahl von Vorlagen möglich. Für jede Meßaufgabe wird der Bedienungsperson eine Vorlage mit den erforderlichen Strichcode zur Verfügung gestellt. Die Einstellvorlagen mit Strichcode können mittels handelsüblichen Druckern auf sehr einfache Weise erstellt werden. Für die Meßgeräteeinstellung für wiederkehrende Meßaufgaben bei Inbetriebnahme, Kontrolle und Reparatur von nachrichtentechnischen Anlagen können die Einstellvorlagen, Pflichtenheften, Reparaturanleitungen und dergleichen beigeheftet sein. Die Bedienungsperson muß lediglich die einzelnen Strichcode nacheinander mit dem Strichcodeleser abtasten, um die Einstellung des Meßgerätes vorzunehmen.

EP-A-0150494 offenbart einen Strichcodeleser zur Dateneingabe mittels bestimmter Codes.

Die Strichcode können eine alphanumerische Zeichenfolge mit Anweisungen und Daten zur Durchführung der Einstellung eines Meßgeräts beinhalten. Die Strichcode können jedoch auch selbst Befehle, beispielsweise einen Reset-Befehl zum Rücksetzen des Meßgerätes enthalten.

Besonders vorteilhaft ist es, die aus den Strichcode abgeleiteten digitalen Informationen in einen Zwischenspeicher abzulegen, damit aus dem Zwischenspeicher die Informationen zeitversetzt und gegebenenfalls auch wiederholt für die Einstellung des Meßgerätes verwendet werden können.

Das Meßgerät kann mit einer Lese- und Steuereinrichtung versehen sein, die an einem Fernsteuereingang des Meßgeräts angeschlossen ist. Die Lese- und Steuereinrichtung erzeugt die erforderlichen Steuersignale in Abhängigkeit von der gelesenen Strichcodeinformation, so daß durch die Verwendung einer derartigen Lese- und Steuereinrichtung es möglich ist, herkömmliche Meßgeräte mit Fernsteuereingang unter Verwendung von Strichcode-Einstellvorlagen auf unterschiedliche Meßaufgaben einzustellen. Der in der Lese- und Steuereinrichtung befindliche separate Prozessor erzeugt die erforderlichen Steuersignale, die über den Fernsteuereingang die Einstellung des Meßgeräts bewirken.

Das Verfahren zum Einstellen eines mittels Steuersignale einstellbaren Meßgeräts sieht vor, daß eine Meßaufgabe charakterisierende Einstellinformationen zunächst als Strichcode ausgedruckt werden, daß die ausgedruckten Strichcode mittels einer Strichcode-Leseeinrichtung in elektrische Steuersignale umgewandelt werden, die die Einstellung auf eine gewünschte Meßaufgabe im Meßgerät bewirken. Dabei kann die Vorlage der Strichcode auf sehr einfache Weise mittels eines Personal-Computers oder dergleichen erzeugt und von einem angeschlossenen Drucker ausgedruckt werden.

Die Erfindung wird nachfolgend anhand der Zeichnung näher erläutert. Es zeigen:
Figur 1 das Blockschaltbild eines Meßgeräts mit einer an seinem Fernsteuereingang angeschlossenen Lese- und Steuereinrichtung,
Figur 2 ein Meßgerät, bei dem die gelesenen Strichcodeinformationen intern zur Einstellung des Meßgeräts verwendet werden, und
Figur 3 ein Ablaufdiagramm zur Herstellung der Einstellvorlage mit Strichcode und zum Einstellen eines Meßgeräts.

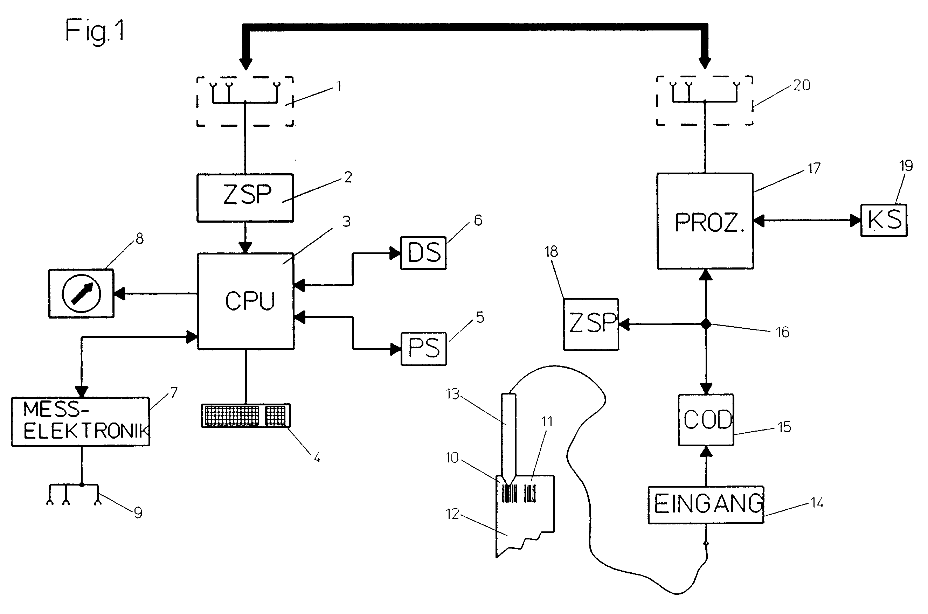

Das in Figur 1 dargestellte Blockschaltbild zeigt auf der linken Seite die wesentlichen Baugruppen eines herkömmlichen Meßgeräts mit einem als Standard-Schnittstelle ausgebildeten Fernsteuereingang 1. Es kann sich herbei um eine Standard-Meßgeräteschnittstelle IEEE 488 bzw. IEC-625 handeln. Über einen Zwischenspeicher 2 ist der Fernsteuereingang 1 mit einem Prozessor 3 verbunden, der mit einer Tastatur 4, einem Programmspeicher 5 und einem Datenspeicher 6 in Verbindung steht. Außerdem sind an den Prozessor 3 die Meßelektronik 7 und eine Anzeigeneinrichtung 8 angeschlossen. Die Meßelektronik 7 führt die erforderlichen Messungen an Meßein- und Ausgängen 9 durch, wobei Meßdaten an der Anzeigeneinrichtung 8 angezeigt werden. Über die Tastatur 4 können die vorzunehmenden Messungen dem Prozessor 3 in Form von alphanumerischen Anweisungen mitgeteilt werden. Die zur Interpretation und Durchführung dieser Anweisungen erforderlichen Informationen sind in dem Programmspeicher 5 und im Datenspeicher 6 abgelegt. Soll beispielsweise ein Meßsignal mit einer Amplitude von 30 mV erzeugt werden, so kann dies beispielsweise durch Eingabe der Anweisung "M30" erfolgen. Weitere Spezifikationen einer durchzuführenden Meßaufgabe, beispielsweise Angaben über den zeitlichen Verlauf des Signals und über die Empfindlichkeit des Meßeinganges, können in einer Liste von Anweisungen vorgegeben sein, die über die Tastatur 4 von einer Bedienungsperson einzugeben sind.

Die entsprechenden Anweisungen können als Strichcode 10, 11 auf Papier 12 gedruckt vorliegen. Mittels eines Lesestifts 13, der zusammen mit einem Strichcodeeingang 14 eine Strichcode-Leseeinrichtung bildet, können die Strichcode in entsprechende elektrische Lesesignale umgewandelt werden. Die Lesesignale werden einem Codierer 15 zugeführt, an dessen Ausgang 16 entsprechende digital codierte Informationen zu einem separaten Prozessor 17 und zu einem Zwischenspeicher 18 übertragen werden. Die codierten Informationen werden durch den Prozessor 17 verarbeitet und bewirken entsprechend ihrer Art eine Informationsänderung des Konfigurationsspeichers 19 oder werden durch den Prozessor 17 als Einstellbefehle und Einstelldaten erkannt und unter Verwendung der im Konfigurationsspeicher 19 enthaltenen systemspezifischen Informationen durch den Prozessor 17 über einen Datenausgang 20 zum Fernsteuereingang 1 als Steuersignale übertragen. Der Prozessor 17 überträgt somit in Form von Steuersignalen die für eine gewünschte Meßaufgabe erforderlichen Anweisungen an den Prozessor 3, der daraufhin die erforderlichen Einstellungen in der Meßelektronik 7 vornimmt und die durchzuführende Messung unter Berücksichtigung der vom Prozessor 17 übertragenen Steuersignale (Anweisungen) veranlaßt.

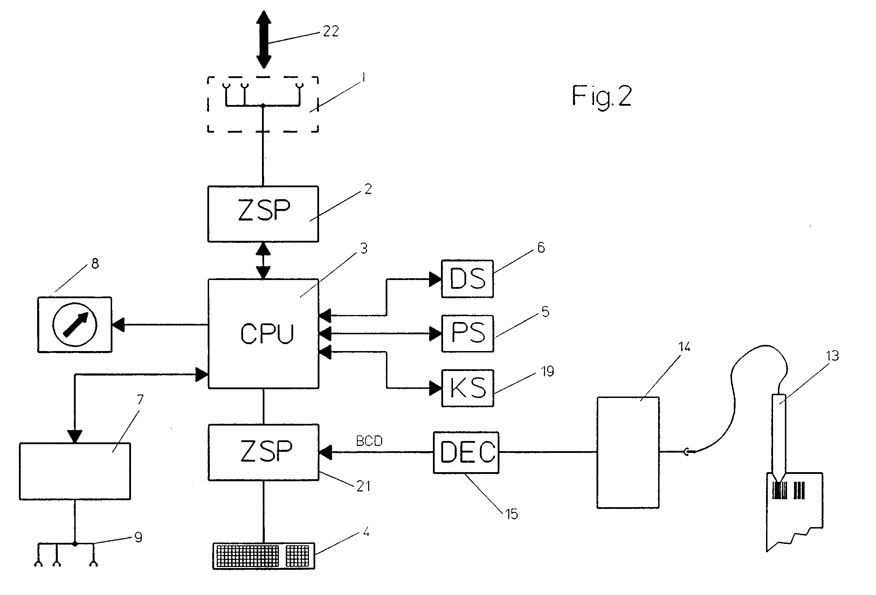

In Figur 2 ist ein Ausführungsbeispiel gezeigt, bei dem der Konfigurationsspeicher 19 direkt mit dem Prozessor 3 in Verbindung steht. Die Strichcode-Leseeinrichtung, bestehend aus Lesestift 13 und Strichcodeeingang 14 gibt die gelesenen Informationen über den Codierer 15 an einen Zwischenspeicher 21 weiter, der Einstellinformationen auch von der Tastatur 4 aufnehmen kann. Die im Zwischenspeicher 21 abgelegten Informationen können vom Prozessor 3 abgefragt werden, so daß der Prozessor 3 in Verbindung mit den im Konfigurationsspeicher 19 enthaltenen Informationen die Einstellung der Meßelektronik 7 und die gewünschte Durchführung einer Meßaufgabe vornimmt. Im Ausführungsbeispiel gemäß Figur 2 ist der Fernsteuereingang 1 unbesetzt, d.h. es kann dort unabhängig von der Strichcode-Leseeinrichtung ein Datenaustausch über einen Datenbus 22 zu entfernten Einrichtungen erfolgen.

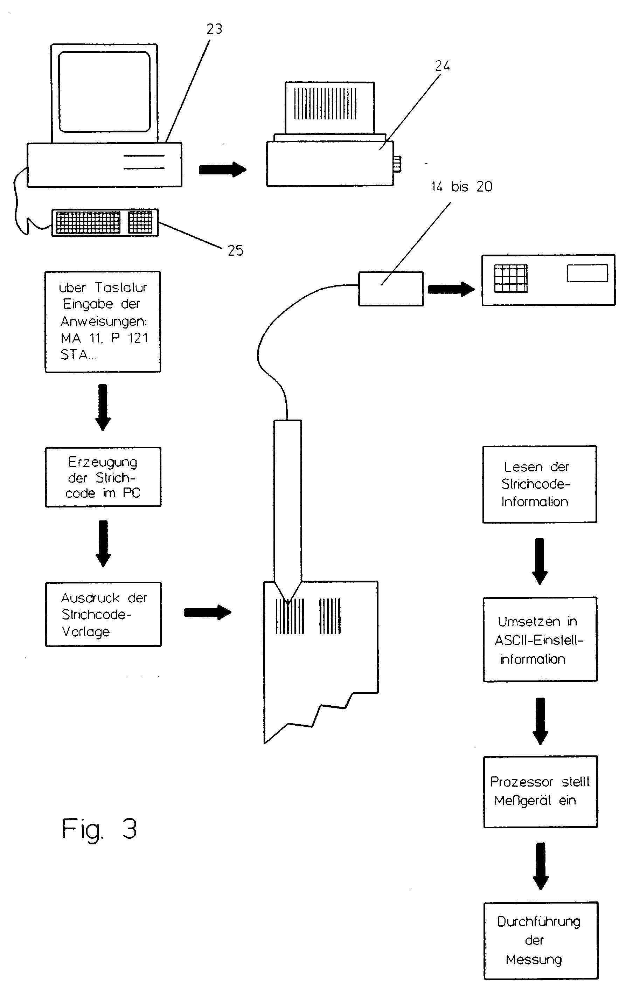

In Figur 3 ist der zeitliche Ablauf der Erstellung einer Strichcodevorlage und der Einstellung eines Meßgerätes unter Verwendung der Strichcodevorlage dargestellt.

Unter Verwendung eines Personal-Computers 23 und eines Druckers 24 können durch ein geeignetes Codierungsprogramm die für die Einstellung eines Meßgerätes auf eine bestimmte Meßaufgabe vorgesehenen alphanumerischen Anweisungen in eine Strichcodevorlage umgesetzt werden. Zu diesem Zweck wird an der Tastatur 25 über die Tastatur eine Vielzahl von Einstellvorschriften in Form von alphanumerischen Anweisungen dem Rechner 23 eingegeben. Die Anweisungen können beispielsweise lauten: MA11, P121, STA. Mit dem im Personal-Computer 23 enthaltenen Übersetzungsprogramm wird aus diesen alphanumerischen Anweisungen eine entsprechende Anzahl von Strichcodierungen erzeugt. Im nächsten Schritt können diese Strichcodierungen am Drucker 24 auf eine Vorlage 26 ausgedruckt werden.

Zur Einstellung des Meßgerätes auf die gewünschte Meßaufgabe werden die Strichcode von der Vorlage 26 mittels eines Lesestiftes gelesen und in digital codierte Informationen umgewandelt, die für einen zugeordneten Prozessor des Meßgerätes verständlich sind. Der Prozessor stellt daraufhin das Mießgerät entsprechend den digitalen Informationen auf die gewünschte Meßaufgabe ein, so daß nun die Messung durchgeführt werden kann.

Für unterschiedliche Meßaufgaben werden entsprechend unterschiedliche Vorlagen 26 verwendet. Eine Fehlbedienung bei der Einstellung des Meßgerätes ist durch dieses Einstellverfahren unter Verwendung von Strichcode praktisch ausgeschlossen.

## Patentansprüche

1. Verfahren für die Einstellung eines mittels elektrischer Steuersignale auf eine gewünschte Meßart und vorgegebene Meßvorschriften einstellbaren Meßgeräts zur Durchführung unterschiedlicher Meßaufgaben, wie Pegelmessung, Dämpfungsmessung oder dergleichen, wobei mindestens ein Prozessor (3, 17) vorgesehen ist, der in Abhängigkeit von den Steuersignalen eines Meßgeräts auf die gewünschte Meßaufgabe einstellt, **dadurch gekennzeichnet**, daß eine Strichcode-Leseeinrichtung (13, 14) vorgesehen ist, die an den Eingang eines Codierers (15) die dem jeweils gelesenen Strichcode (11) entsprechenden elektrischen Lesesignale überträgt, daß der Codierer (15) die Lesesignale in digital codierte Informationen umwandelt, die dem Prozessor (3, 17) zugeführt werden, daß der Prozessor (3, 17) diese codierten Informationen in Einstelldaten und Einstellbefehle umsetzt, daß der Prozessor (3, 17) mit einem Konfigurationsspeicher (19) verbunden ist, aus dem systemspezifische Informationen abgerufen werden, daß der Prozessor (3, 17) aus Einstelldaten, Einstellbefehlen und bei Vorhandensein von systemspezifischen Informationen die zur Einstellung der gewünschten Meßaufgabe erforderlichen Steuersignale erzeugt, daß die aus den Lesesignalen erzeugten codierten Informationen die Adressen des Konfigurationsspeichers (19) enthalten, unter denen wiederholt benötigte Einstellbefehle und Einstelldaten sowie Systemparameter abgespeichert sind.

2. Verfahren nach Anspruch 1, **dadurch gekennzeichnet**, daß die codierten, digitalen Informationen in einem mit dem Prozessor (3, 17) verbundenen Zwischenspeicher (18) abgelegt werden.

3. Verfahren nach einem der Ansprüche 1 oder 2, dadurch gekennzeichnet, daß eine Meßaufgabe charakterisierende Einstellinformation zunächst als Strichcode (10,11) ausgedruckt wird.

4. Meßgerät zur Durchführung des Verfahrens nach einem der vorhergehenden Ansprüche, **dadurch gekennzeichnet**, daß in einer an einem Fernsteuereingang (1) des Meßgerätes angeschlossenen Lese- und Steuereinrichtung (13, 14) zur Erzeugung der zur Einstellung des Meßgeräts erforderlichen Steuersignale ein separater Prozessor (17) vorgesehen ist, der mit dem Codierer (15), einem Zwischenspeicher (18) und dem Konfigurationsspeicher (19) verbunden ist, und dessen der Steuersignale übertragender Ausgang (20) an einen Fernsteuereingang (1) des Meßgeräts angeschlossen ist.

## Claims

1. Method of adjusting a measuring apparatus, which is adjustable to a desired type of measuring and to prescribed measuring instructions by means of electrical control signals, in order to accomplish various measuring tasks, such as level measuring, attenuation measuring or the like, at least one processor (3, 17) being provided, which adjusts to the desired measuring task in dependence on the control signals of a measuring apparatus, characterised in that a bar code reading device (13, 14) is provided, which transmits the electrical reading signals, corresponding to the actual bar code (11) being read, to the input of an encoder (15), in that the encoder (15) converts the reading signals into digitally coded information which is supplied to the processor (3, 17), in that the processor (3, 17) changes this coded information into adjustment data and adjustment commands, in that the processor (3, 17) is connected to a configuration memory (19), from which memory information specific to the system is recalled, in that the processor (3, 17) generates the control signals, which are required for the adjustment of the desired measuring task, from adjustment data, adjustment commands and, if present, from information specific to the system, in that the coded information produced from the reading signals contains the addresses of the configuration memory (19), under which addresses repeatedly required adjustment commands and adjustment data, as well as system parameters, are stored.

2. Method according to claim 1, characterised in that the coded digital information is stored in an intermediate memory (18) connected to the processor (3, 17)

3. Method according to one of claims 1 or 2, characterised in that adjustment information, characterising a measuring task, is initially expressed as a bar code (10, 11).

4. Measuring apparatus for accomplishing the method according to one of the preceding claims, characterised in that a separate processor (17) is provided in a reading and controlling device (13, 14), which is connected to a remote control input (1) of the measuring apparatus, in order to generate the control signals required for the adjustment of the measuring apparatus, said processor being connected to the encoder (15), an intermediate memory (18) and the configuration memory (19), and the output (20) of said processor, which transmits the control signals, being connected to a remote control input (1) of the measuring apparatus.

## Revendications

1. Procédé pour le réglage d'un appareil de mesure destiné à réaliser différents travaux de mesure tels qu'une mesure de niveau, d'affaiblissement, etc, et réglable à l'aide de signaux de commande électriques sur un mode de mesure souhaité et sur des prescriptions de mesure prédéfinies, étant précisé qu'il est prévu au moins un processeur (3, 17) qui effectue le réglage sur le travail de mesure souhaité, en fonction des signaux de commande d'un appareil de mesure, caractérisé en ce qu'il est prévu un dispositif de lecture de codes barres (13, 14) qui transmet à l'entrée d'un codeur (15) les signaux de lecture électriques correspondant au code barres (11) lu à chaque fois, en ce que le codeur (15) convertit les signaux de lecture en informations codées numériquement qui sont transmises au processeur, (3, 17), en ce que le processeur (3, 17) convertit ces informations codées en données et en instructions de réglage, en ce que le processeur (3, 17) est relié à une mémoire de configuration (19) à partir de laquelle sont appelées les informations spécifiques du système, en ce que le processeur (3, 17) génère, à partir des données et instructions de réglage et en présence d'informations spécifiques du système, les signaux de commande nécessaires au réglage du travail de mesure souhaité, et en ce que les informations codées générées à partir des signaux de lecture contiennent les adresses de la mémoire de configuration (19) auxquelles des instructions et des données de réglage nécessaires de façon répétée et des paramètres de système sont mis en mémoire.

2. Procédé selon la revendication 1, caractérisé en ce que les informations numériques codées sont déposées dans une mémoire intermédiaire (18) reliée au processeur (3, 17).

3. Procédé selon l'une des revendications 1 ou 2, caractérisé en ce qu'une information de réglage caractérisant un travail de mesure est tout d'abord imprimée sous la forme d'un code barres (10, 11).

4. Appareil de mesure pour la mise en oeuvre du procédé selon l'une des revendications précédentes, caractérisé en ce qu'il est prévu, dans un dispositif de lecture et de commande (13, 14) relié à une entrée de télécommande (1) de l'appareil de mesure, pour générer les signaux de commande nécessaires au réglage de l'appareil de mesure, un processeur séparé (17) qui est relié au codeur (15), à une mémoire intermédiaire (18) et à la mémoire de configuration (19), et dont la sortie (20) transmettant les signaux de commande est reliée à une entrée de télécommande (1) de l'appareil de mesure.
